# EUROPEAN PATENT APPLICATION

(11) **EP 1 531 361 A2**
(43) Date of publication of application: **18.05.2005**
(21) Application number: 04292684.0
(22) Date of filing: 12.11.2004
(51) Int. Cl.: G03F 1/16

(54) **Stencil mask and method of producing the same**

(30) Priority: 12.11.2003 JP 2003382260
(71) Applicant: SONY CORPORATION, Tokyo (JP); ROHM CO., LTD., Kyoto (JP)
(72) Inventor: Hirakawa, Tadahiko, Sony Semi Cond. Kyushu Corp., Fukuoka-shi Fukuoka (JP); Kumano, Hiroshi, c/o Rohm Co., Ltd., Kyoto (JP)
(74) Representative: Thévenet, Jean-Bruno

(57) **Abstract**

A stencil mask has a thin film (11) having an aperture pattern (13). A material layer (14) having heat conductance higher than that of the thin film (11) is set in a region except for a portion (c) of outer edge of the aperture pattern (13) in the side of a principal surface of the thin film (11).

The invention further relates to a method for producing such a stencil work.

## Description

### BACKGROUND OF THE INVENTION

### 1. Field of the Invention

The present invention relates to a stencil mask, in particular to a stencil mask used for a technology of manufacturing a semiconductor using a charged particle beam.

### 2. Description of the Related Art

In recent years, miniaturization and high integration of semiconductor devices have progressed more and more and a technology of manufacturing a semiconductor, performing a process of sub-quarter micrometer at a high accuracy and repeatability is strongly required. As a technology of manufacturing the semiconductor, there is known a direct-drawing method where microscopic patterns are drawn by scanning with an electron beam and so on, when forming microscopic patterns on a wafer, in other words a semiconductor substrate.

However, since the processing time of direct-drawing method is very long, by performing exposure with using a stencil mask having aperture patterns in the thin film, an electron beam and so on is irradiated to the wafer selectively and microscopic patterns are formed, and accordingly a reduction of processing time is intended.

A stencil mask makes it possible to use several applications such as not only an exposure process, but an ion implantation process, a process of forming a film and so on. For example, a stencil mask may be applied to an ion implantation process. An example that an ion is selectively implanted by irradiating an ion beam to a processing substrate through a stencil mask placed on the upper side of the processing substrate is reported (For example, refer to Japanese Unexamined Patent Publication No. 1999-288680).

Since by using a stencil mask for an ion implantation process a resist pattern may not be formed on a processing substrate, then, resist coating before an ion implantation, exposure, patterning by developing and resist stripping after an ion implantation, can be reduced, and an ion implantation process in a short time becomes possible. Moreover, since wet-etching when developing or resist stripping may not be performed because of not forming a resist mask, generation of residual by wet-etching can be prevented, as a result surface contamination of the wafer is avoided.

However, since ions are irradiated to a stencil mask placed on a processing substrate, the temperature of the stencil mask rises significantly, components of the mask easily expand, and warpage or distortion is easily generated in the stencil mask. To prevent deformation of the stencil mask like this, there is an example that an electric conductive layer having high heat conductance on the surface of a stencil mask is formed and heat is radiated (refer to Japanese Unexamined Patent Publication No. 1997-5985).

However, in the above stencil mask where the electric conductive layer is set, by placing the stencil mask on the upper side of the processing substrate aiming the electric conductive layer at the process substrate and irradiating a charged particle beam such as an ion beam and so on to the process substrate through this stencil mask, when the charged particle beam passes an aperture pattern, a charged particle frequently collides to the electric conductive layer covering a portion of outer edge of the aperture pattern.

Therefore, since the electric conductive layer is sputtered and conductive contamination is generated, the inside of a device of irradiating the charged particle beam had tended to be contaminated. Moreover, there is a problem that if the conductive contamination is deposited on the surface of the process substrate, since by generating a leakage current a failure arises in a device of producing the process substrate, the yield of this device is lost.

### SUMMARY OF THE INVENTION

To overcome the above problem, a first stencil mask of the present invention has a thin film having an aperture pattern and a material layer set in a region except for a portion of outer edge of said aperture pattern in the side of a principal surface of said thin film and having heat conductance higher than that of said thin film.

According to the first stencil mask having such a construction, the portion of outer edge of the aperture pattern in the thin film is not covered by the material layer for radiating the heat arising in the surface of the thin film. Hence, in the case that the stencil mask is placed on the upper side of the supporting substrate by aiming the material layer at the side of the processing substrate and the charged particle beam is irradiated to the processing substrate through this stencil mask, it can be prevented that the material layer is exposed the charged particle beam. Hence, sputtering of the material layer by the charged particle beam is prevented, generation of contamination can be avoided.

Further, in the case that the protective film is set in a state of covering the material layer, since sputtering of the material layer by the charged particle beam is surely prevented and lack of the material layer by the heat or stress is also prevented, generation of contamination can be prevented more surely.

Moreover, a method of producing the first stencil mask of the present invention, has a step of forming a thin film on a supporting substrate, a step of forming an aperture pattern reaching said supporting substrate on a thin film covering the inside of a portion around the edge of said supporting substrate, a step of forming a material layer having heat conductance higher than that of said thin film to cover said thin film in which said aperture pattern is formed, a step of removing said material layer covering on said aperture pattern and a portion of outer edge of said aperture pattern, and a step of removing inside a portion around the edge of said supporting substrate to expose said thin film.

According to the method of producing such a first stencil mask, the material layer covering on the aperture pattern and the portion of outer edge of the aperture pattern is removed. Herewith, a stencil mask in a state that the portion of outer edge of the aperture pattern in the thin film is not covered with the material layer can be produced.

Moreover, the second stencil mask of the present invention has a thin film having an aperture pattern, a supporting substrate supporting a portion around the edge of said thin film, a material layer set in a region except for a portion of outer edge of said aperture pattern in the side of a principal surface of said thin film and having heat conductance higher than that of said thin film, and a plug embedded in a state of contacting with said thin film, reaching inside of said supporting substrate and having heat conductance higher than that of said thin film and said supporting substrate.

According to the second stencil mask having such a construction, as well as the first stencil mask, since the portion of outer edge of the aperture pattern is not covered with the material layer, it can be prevented that the material layer is exposed the charged particle beam. Hence, sputtering of the material layer by the charged particle beam is prevented, generation of contamination can be avoided. Moreover, a plug having heat conductance higher than that of the thin film and the supporting substrate is embedded in a state of contacting with the thin film and reaches inside of the supporting substrate. Here, However, the stencil mask is normally used in a vacuum condition, generally, in a vacuum condition, the radiation of the heat generated in the surface of the stencil mask into the inside of the stencil mask tends to be more rapid than the radiation into vacuum. Hence, the heat arising in the surface of the thin film of the stencil mask can be radiated into the supporting substrate quickly through the plug. In the case that the material layer is communicated with the plug, the heat arising in the surface of the thin film is radiated from the thin film to the material layer, and is radiated from the material layer into the supporting substrate quickly through the plug.

Moreover, a method of producing the second stencil mask of the present invention, has a step of forming a thin film on a supporting substrate, a step of forming an aperture pattern reaching said supporting substrate in said thin film covering inside a portion around the edge of said supporting substrate and forming an aperture portion reaching inside of said supporting substrate in said thin film covering inside a portion around the edge of said supporting substrate and in said supporting substrate, a step of forming a material layer having heat conductance higher than that of said thin film to cover said thin film in which said aperture pattern is formed and forming a plug having heat conductance higher than that of said thin film and said supporting substrate at said aperture portion, and a step of patterning said material layer to remove said material layer covering on said aperture pattern and inside a portion of outer edge of said aperture pattern, and a step of removing inside a portion around the edge of said supporting substrate to expose said thin film.

According to such a method of producing of the second stencil mask, the plug having heat conductance higher than that of the thin film and the supporting substrate is formed at the aperture portion that penetrates the thin film covering the portion around the edge of the supporting substrate and that reaches inside of the supporting substrate. Moreover, the material layer covering on the aperture pattern and the portion of outer edge of the aperture pattern is removed. Herewith, a stencil mask in a state that the portion of outer edge of the aperture pattern in the thin film is not covered with the material layer can be produced. Further, if this material layer is communicated with the plug, a stencil mask that the heat arising in the surface of the thin film can be radiated into the supporting substrate quickly through the material layer and the plug can be produced. Moreover, in the case that the material layer and the plug are formed with a same material, the material layer and the plug can be formed at a same process.

According to the first stencil mask of the present invention, since the portion of outer edge of the aperture pattern is not covered by the material layer, even if the stencil mask is placed on the upper side of the supporting substrate by aiming the material layer at the side of the processing substrate and the charged particle beam is irradiated to the processing substrate through this stencil mask, exposing the material layer to the charged particle beam can be prevented. Hence, sputtering of the material layer by the charged particle beam can be prevented, generation of contamination can be avoided. Hence, it can be prevented that the inside of a device of irradiating the charged particle beam is contaminated by contamination. Moreover, since deposition of contamination to the surface of the processing substrate can be prevented, the problem of the device formed on the processing substrate can be resolved. Therefore, the yield of this device can be improved.

Further, in the case that the protective film is set in a state of covering the material layer, since sputtering the material layer by the charged particle beam is surely prevented and lack of the material layer by the heat or stress is also prevented, generation of contamination can be prevented more surely.

Moreover, According to the method of the first stencil mask, by patterning the material layer, since the material layer covering on the aperture pattern and the portion of outer edge of the aperture pattern is removed, a stencil mask in a state that the portion of outer edge of the aperture pattern is not covered with the material layer can be produced.

According to the second stencil mask of the present invention, as well as the first stencil mask, since the portion of outer edge of the aperture pattern is not covered with the material layer, effects similar to the first stencil mask can be obtained. Moreover, since the plug having heat conductance higher than that of the thin film and the supporting substrate is embedded in a state of penetrating the thin film and reaches the supporting substrate, the heat arising in the surface of the thin film by irradiation of the charged particle beam can be radiated quickly into the supporting substrate through the plug. Hence, deformation such as warpage or distortion because of the heat of the stencil mask can be prevented. Therefore, when placing the stencil mask on the upper side of the processing substrate with a predetermined interval, the contact of stencil mask and the processing substrate because of deformation by the heat can be prevented, and the interval from the stencil mask in all region of the processing substrate can be kept. Further, since deformation of the aperture pattern by the heat can be prevented, displacement and deformation of the region that the charged particle beam is irradiated can be prevented. Moreover, in the case that the material layer is communicated with the plug, the heat arising in the surface of the thin film can be radiated into the supporting substrate through the material layer and the plug more quickly.

According to the method of producing of the second stencil mask of the present invention, the plug having heat conductance higher than that of the thin film and the supporting substrate is formed at the aperture portion that penetrates the thin film covering the portion around the edge of the supporting substrate and that reaches inside of the supporting substrate. Moreover, by patterning the material layer, since the material layer covering on the aperture pattern and the portion of outer edge of the aperture pattern is removed, a stencil mask in a state that the portion of outer edge of the aperture pattern is not covered with the material layer can be produced. Further, by making the material layer being communicated with the plug, the stencil mask that the heat arising in the surface of the thin film of the stencil mask can be radiated into the supporting substrate through the material layer and the plug more quickly can be produced. Moreover, in the case that the material layer and the plug are formed with a same material, the material layer and the plug can be formed at a same process.

### BRIEF DESCRIPTION OF THE DRAWINGS

FIG. 1A and FIG. 1B are cross sectional views of a stencil mask in a first embodiment according to the invention.
FIG. 2A to FIG. 2P are cross sectional process views showing a process of producing a stencil mask in the first embodiment.
FIG. 3 is a cross sectional view of the stencil mask of a second embodiment of the invention.
FIG. 4A to FIG. 4K are cross sectional process views showing a process of producing a stencil mask in the second embodiment.

### DESCRIPTION OF THE PREFERRED EMBODIMENTS

Preferred embodiments of the present invention will be described with reference to the accompanying drawings.

### (The first embodiment)

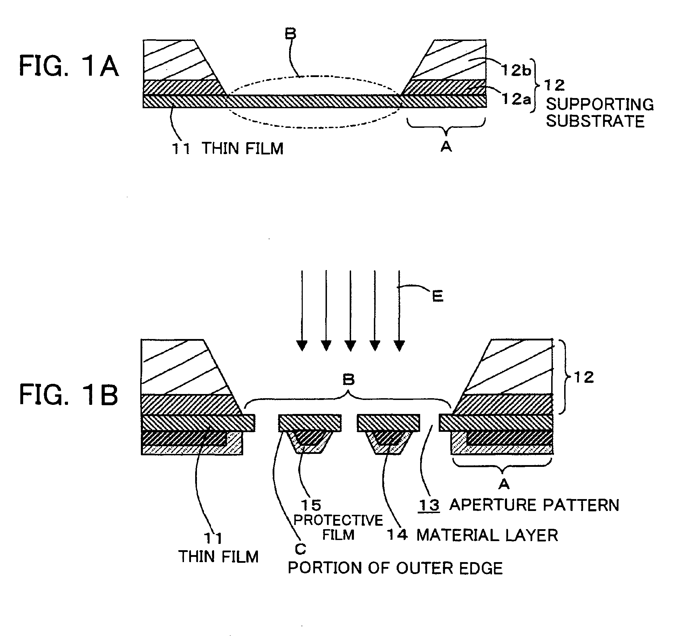

FIG. 1A is a schematic cross sectional view showing an example of the embodiment of the first stencil mask in the present invention, FIG. 1B is a cross sectional view showing the construction of the first stencil mask. The stencil mask shown in this view is used for the technique of producing a semiconductor performing processes such as an ion implantation process or an exposure process and so on to the processing substrate by irradiating a charged particle beam such as an ion or an electron beam and so on.

As shown in FIG. 1A, in the stencil mask in the present embodiment, a thin film 11 is set in the side of a surface of a frame-shaped supporting substrate 12, a portion of outer edge of the thin film 11 is supported by the supporting substrate 12. A portion supported by the supporting substrate 12 is defined as a supporting portion A, a portion of the thin film 11 set in the frame of the supporting substrate 12 is defined as a membrane portion B. The supporting substrate 12 consists of an insulating film 12a and a substrate 12b, and is a laminated structure in which the substrate 12b is set in the portion around the edge of the thin film 11 through the insulating film 12a. Here, the thin film 11 is formed with silicon (Si) single crystal, the insulating film 12a is formed with silicon oxide and the substrate 12b is formed with Si single crystal.

Further, as shown in FIG. 1B, in a region constituting the membrane portion B in the thin film 11, an aperture pattern 13 for passing a charged particle beam E is set. Moreover, in the opposite side of the surface of the thin film 11 in which the supporting substrate 12 is set, a material layer 14 that radiates the heat arising in the surface of the thin film 11 by irradiation of the charged particle beam E, and a protective film 15 for protecting the material layer 14 from the charged particle beam E in a state of covering this material layer 14.

Here, in the present embodiment, the side of the surface on which the supporting substrate 12 is set in the thin film 11 is defined as the upper side of the thin film 11, the surface on which the material layer 14 is set is defined as the lower side of the thin film 11. This stencil mask is located in a state of aiming the material layer 14 at the side of the processing substrate and having a predetermined interval on the upper side of the processing substrate. The stencil mask is used by irradiating the charged particle beam E to the membrane portion B having the aperture pattern 13 from the upper side of the thin film 11. However, there may be the case that the supporting substrate 12 is set on the same side of the material layer 14, even if in that case, the stencil mask is used in a state of aiming the material layer 14 at the side of the processing substrate.

Here, the material layer 14 is formed with a material having heat conductance higher than that of the thin film 11. This material is, for example, a conductive material such as aluminum (Al), gold (Au), silver (Ag), copper (Cu) and so on or diamond and so on. Here the material layer 14 is formed with, for example, the conductive material consisting of Al.

The material layer 14 in the stencil mask in the present embodiment is set in a region except for a portion of outer edge C of the aperture pattern 13 in the thin film 11. Here, for example, the material layer 14 has an aperture pattern that has the shape of the aperture pattern 13 and is slightly expanded i.e. the material layer 14 is set in all over the region except for the portion of outer edge C of the aperture pattern 13 in the thin film 11. Further, this material layer 14 is set not only in the membrane portion B but in the thin film 11 constituting the supporting portion A continuously.

Here, the portion of outer edge C is the region where the charged particles are diffracted on the edge of the aperture pattern 13. The charged particles reflected in the processing substrate and the materials emitted from the processing substrate by irradiating the charged particles frequently collide when placing the stencil mask on the upper side of the processing substrate with the material layer 14 aiming at the processing substrate and irradiating the charged particle beam E to the processing substrate through this stencil mask.

Note that, here, the material layer 14 is set in all over the region except for the portion of outer edge C, however, the present invention is not limited to this, if in a region except for the portion of outer edge C, that may be set in island-shaped. However, since the material layer 14 prevents the temperature from rising in the membrane portion B where the charged particle beam E is irradiated, it is so preferable that the material layer 14 may be set in as a large range as possible including the membrane portion B.

For protecting the material layer 14 from the charged particle beam E and preventing lack of the material layer 14 by the heat or stress, a protective film 15 is set in a state of covering the surface of the material layer 14. Moreover, it is preferable that the protective film 15 is formed with more durable material for the charged particle beam E than the material layer 14. Such a material may be a silicon nitride (SiN) film, a tetraethoxysilane (TEOS) film, a Si single crystal film or an oxide film of the material layer 14 such as aluminum oxide and so on. Here, the protective film 15 is formed with a SiN film.

Here, the protective film 15 is formed, in particular, in a state of covering the side of the aperture pattern 13 of the material layer 14 for protecting the material layer 14 from the charged particle beam E. Here, for example, the protective film 15 having an aperture pattern (not shown in the drawings) that is expanded one size larger than the circumstance shape of the aperture pattern 13 in the thin film 11 and is reduced one size smaller than an aperture pattern of the material layer 14 (not shown in the drawings) is set in all over the region except for the portion of outer edge C of the aperture pattern 13. In this case, the material layer 14 is formed with having an aperture pattern one size larger than the portion of outer edge C of the aperture pattern 13.

Note that, here, an example that the protective film 15 is set in a state of covering the material layer 14 is explained, however, the protective film 15 may not be set. Further, the protective film 15 is formed in the region except for the portion of outer edge C of the aperture pattern 13, however, in the case that the protective film 15 is constituted with a material that is hard to be sputtered by the charged particle beam E, it may be set in the portion of outer edge C of the aperture pattern 13 that the charged particle beam E frequently collides. However, for preventing generation of contamination more surely, it is so preferable that the protective film 15 is set in a state of covering the material layer 14, it is more preferable that the protective film 15 is set in s region except for the portion of outer edge C of the aperture pattern 13.

According to the first stencil mask having such a construction, since the portion of outer edge C of the aperture pattern 13 is not covered by the material layer 14, even if the stencil mask is placed on the upper side of the supporting substrate by aiming the material layer 14 at the side of the processing substrate and the charged particle beam E is irradiated to the processing substrate through this stencil mask, it can be prevented that the material layer 14 is exposed the charged particle beam E. Hence, sputtering of the material layer 14 by the charged particle beam E can be prevented, generation of contamination can be avoided. Herewith, it can be prevented that the inside of a device of irradiating the charged particle beam E is contaminated by contamination. Moreover, since deposition of contamination to the surface of the processing substrate can be prevented, the problem of the device formed on the processing substrate can be resolved. Therefore, the yield of this device can be improved.

Moreover, according to the stencil mask of the present invention, by setting the protective film 15 in a state of covering the material layer 14, since sputtering of the material layer 14 by the charged particle beam E is surely prevented and lack of the material layer 14 by the heat or stress is also prevented, generation of contamination can be prevented more surely. Further, since the protective film 15 is also set in a region except for the portion of outer edge C of the aperture pattern 13, sputtering of the protective film 15 in itself by the charged particle beam E can be prevented.

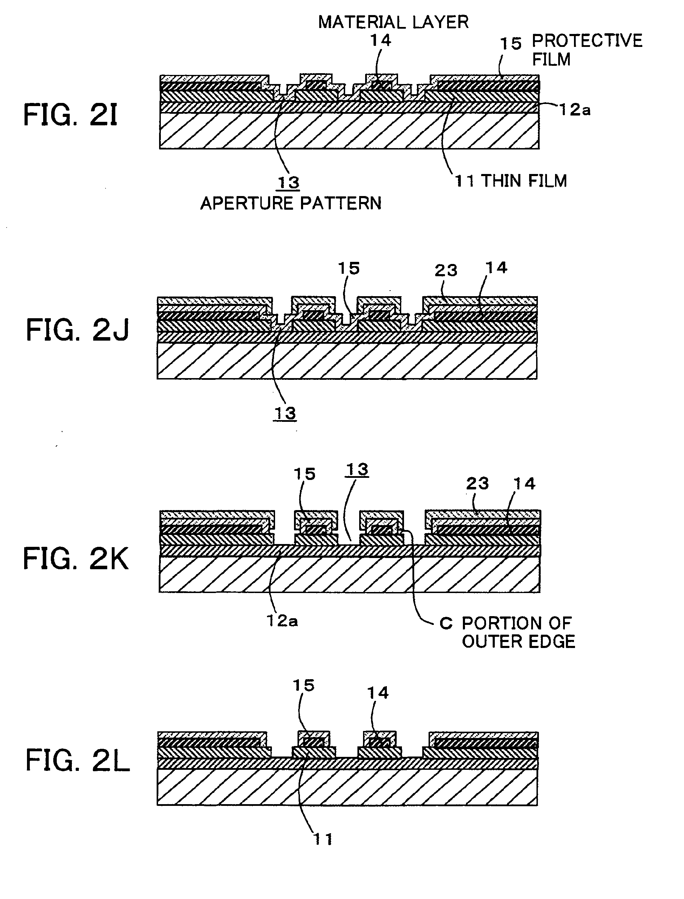

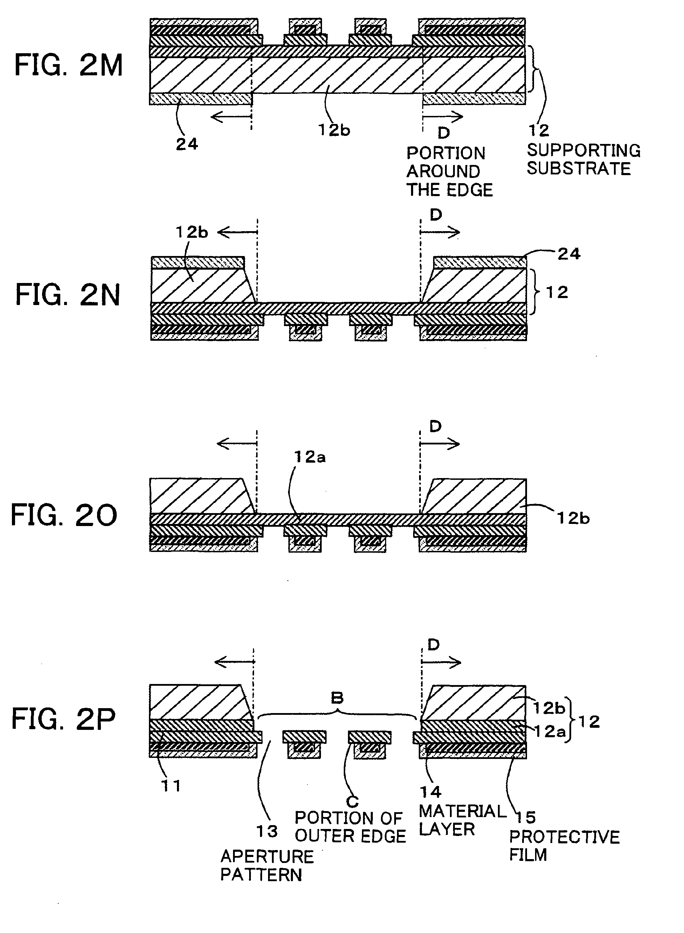

Next, an example of the embodiment in connection with a method of producing a stencil mask in the present embodiment will be explained with cross sectional views of manufacturing process of FIG. 2A to FIG. 2P.

First, as shown in FIG. 2A, a supporting substrate 12 is made by forming an insulating film 12a consisting of for example silicon oxide on a substrate 12b consisting of for example Si single crystal, afterward a thin film 11 consisting of for example Si single crystal is formed on the insulating film 12a. Here the thin film 11 and the supporting substrate 12 have SOI, that is an abbreviation of Silicon on Insulator, construction.

Here, a portion around the edge D of the supporting substrate 12 and the thin film 11 on the portion around the edge D constitute the supporting portion A, that is referred to said FIG. 1A, the thin film 11 inside the portion around the edge D constitutes the membrane portion B that is referred to FIG. 1A.

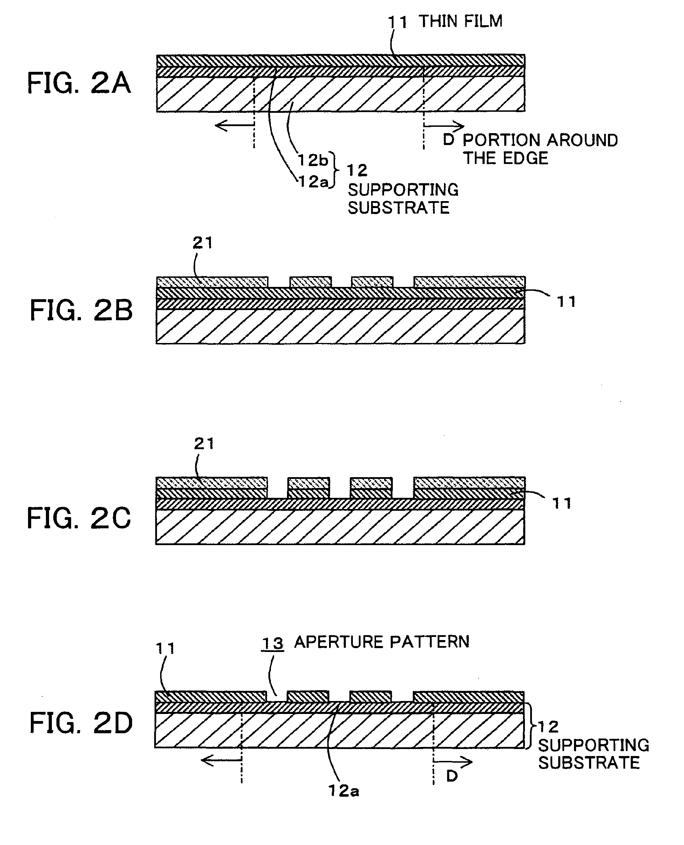

Next, as shown in FIG. 2B, a resist pattern 21 is formed on the thin film 11. Afterward, as shown in FIG. 2C, by an etching using the resist pattern 21 for the mask, the thin film 11 is removed. Afterward, the resist pattern 21 is performed ashing removal. By the above process, as shown in FIG. 2D, an aperture pattern 13 reaching the insulating film 12a is formed in the thin film 11 covering inside the portion around the edge D of the supporting substrate 12.

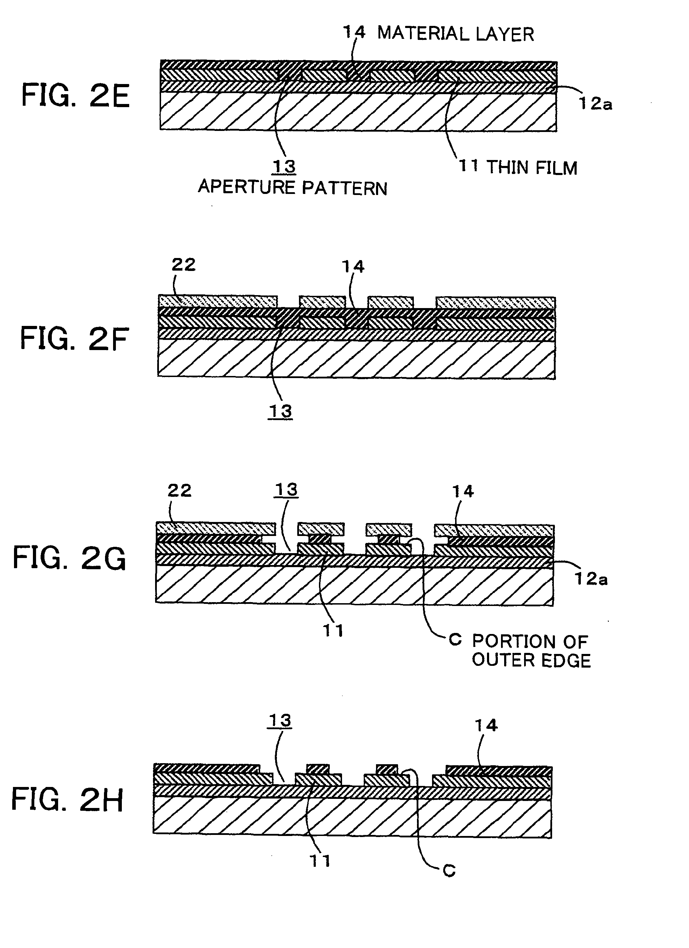

Next, as shown in FIG. 2E, a material layer 14 is formed on the insulating film 12a to cover the thin film 11 that the aperture pattern 13 is formed. Afterward, as shown in FIG. 2F, a resist pattern 22 is formed on the material layer 14 to expose the material layer 14 on the aperture pattern 13. Next, as shown in FIG. 2G, the material layer 14 covering a portion of outer edge C of the aperture pattern 13 in the thin film 11 is removed by removing the material layer 14 on the aperture pattern 13 to expose the insulating film 12a with an etching that the resist pattern 22 is used as a mask and by over etching.

Here, the resist pattern 22 is formed with a pattern equal to the aperture pattern 13 by using the exposure mask equal to the resist pattern 21 used when forming the aperture pattern 13 as explained in FIG. 2C. By using such a resist pattern 22, the material layer 14 covering the portion of outer edge C of the aperture pattern 13 is removed by over etching. Note that, here, the material layer 14 covering the portion of outer edge C is removed by using the resist pattern 22 that is formed with a pattern equal to the aperture pattern 13 and by over etching, however, by using a resist pattern performed patterning one size larger than the aperture pattern 13 (not shown in the drawings), the material layer 14 covering the portion of outer edge C may be removed. In this case, over etching may not be performed. Afterwards, the resist pattern 22 is performed ashing removal.

Herewith, as shown in FIG. 2H, the material layer 14 is formed to cover the region except for the portion of outer edge C of the aperture pattern 13.

Next, as shown in FIG. 2I, by for example the Plasma Enhanced Chemical Vapor Deposition (P-CVD) method, a protective film 15 consisting of for example a SiN film is formed on the insulating film 12a to cover the thin film 11 in which the aperture pattern 13 and the material layer 14 is set.

Here, the protective film 15 consisting of a SiN film is formed by the P-CVD method, however, the present embodiment is not limited to this, for example, a TEOS film may be formed by the P-CVD method. Moreover, in the case that a Si single crystal film is formed as the protective film 15, it may be formed by the sputtering method. Moreover, since the material layer 14 is formed with Al, by performing a passive state process of the surface of the material layer 14 by the heat treatment, the protective film 15 consisting of an oxide film of the material layer 14, here aluminum oxide (Al₂O₃) film may be formed. This passive state process of the material layer 14 may be applied not only in the case where the material layer 14 is formed with Al, but also in the case where it is formed with another conductive material such as Au, Ag, Cu and so on.

Next, as shown in FIG. 2J, the resist pattern 23 is formed on the protective film 15 in a state where the protective film 15 on the aperture pattern 13 is exposed. Afterward, as shown in FIG. 2K, the protective film 15 on the aperture pattern 13 is removed by an etching where the resist pattern 23 is used as the mask to expose the insulating film 12a, and the protective film 15 covering the portion of outer edge C of the aperture pattern 13 is removed by over etching.

Here, the resist pattern 23 is formed with a pattern equal to the resist pattern 21 used when forming the aperture pattern 13 as explained in FIG. 2C, and is formed with a pattern corresponding to the aperture pattern 13. By using such a resist pattern 23, the protective film 15 covering the portion of outer edge C of the aperture pattern 13 is removed by over etching. Note that, by using a resist pattern performed patterning one size larger than the aperture pattern 13 (not shown in the drawings), the protective film 15 covering the portion of outer edge C may be removed. In this case, over etching may not be performed. Afterwards, the resist pattern 22 is performed ashing removal.

Moreover, as mentioned above, in the case that the protective film 15 consists in an oxide film of the material layer 14 by performing a passive state process in the surface of the material layer 14, since the protective film 15 is formed in only the surface of the material layer 14, the etching process of the protective film 15 is omitted. Moreover, here the protective film 15 covering the portion of outer edge C of the aperture pattern 13 is removed, but in the case that the protective film 15 is constituted with a material that is hard to be sputtered, the protective film 15 covering the portion of outer edge may not be removed.

Herewith, as shown in FIG. 2L, the material layer 14 on the thin film 11 becomes in a state of being covered by the protective film 15.

Next, as shown in FIG. 2M, a resist pattern 24 is formed on the lower side of the substrate 12b in the portion around the edge of the supporting substrate 12. As shown in FIG. 2N, the entire stencil mask is turned upside down. Afterward, by a dry-etching where the resist pattern 24 is used as a mask with using an etching gas such as for example carbon tetrafluoride or sulfur hexafluoride, the substrate 12b inside the portion around the edge D of the supporting substrate 12 is removed. After exposing the insulating film 12a inside the portion around the edge D, as shown in FIG. 20, the resist pattern 24 is performed ashing removal. As well, here the substrate 12b is removed by a dry-etching. However, the substrate 12b may be removed by a wet-etching where for example a solution of potassium hydroxide is used as an etchant.

Next, as shown in FIG. 2P, the thin film 11 is exposed by performing etching removal where this processed substrate 12b is used as a mask on the insulating film 12a inside the portion around the edge D of the supporting substrate 12 and the membrane portion B is formed.

According to such a first method of producing the stencil mask, as explained by using FIG. 2E ~ FIG. 2G, after the material layer 14 is formed on the insulating film 12a to cover the thin film 11 where the aperture pattern 13 is formed, the material layer 14 on the aperture pattern 13 is removed by an etching where the resist pattern 22 is used as a mask and the material layer 14 covering the portion of outer edge C of the aperture pattern 13 is also removed. Hence, the stencil mask in a state where the portion of outer edge C of the aperture pattern 13 is not covered by the material layer 14 can be produced.

Moreover, as explained by using FIG. 2I ~ FIG. 2K, after the protective film 15 is formed on the insulating film 12a to cover the thin film 11 in which the aperture pattern 13 is formed and the material layer 14, the protective film 15 on the aperture pattern 13 is removed by an etching where the resist pattern 23 is used as a mask and the protective film 15 covering the portion of outer edge C of the aperture pattern 13 is also removed. Hence, the stencil mask in a state where the protective film 15 covers the material layer 14 and where the portion of outer edge C of the aperture pattern 13 is not covered by the protective film 15 can be produced.

Further, since the same exposure mask can be used for the patterning of the resist pattern 21 used when the aperture pattern 13 is formed as explained by using FIG. 2C, the resist pattern 22 used when the material layer 14 is removed as explained by using FIG. 2G and the resist pattern 23 used when the protective mask 15 is removed as explained by using FIG. 2K, the production cost can be held down.

### (The second embodiment)

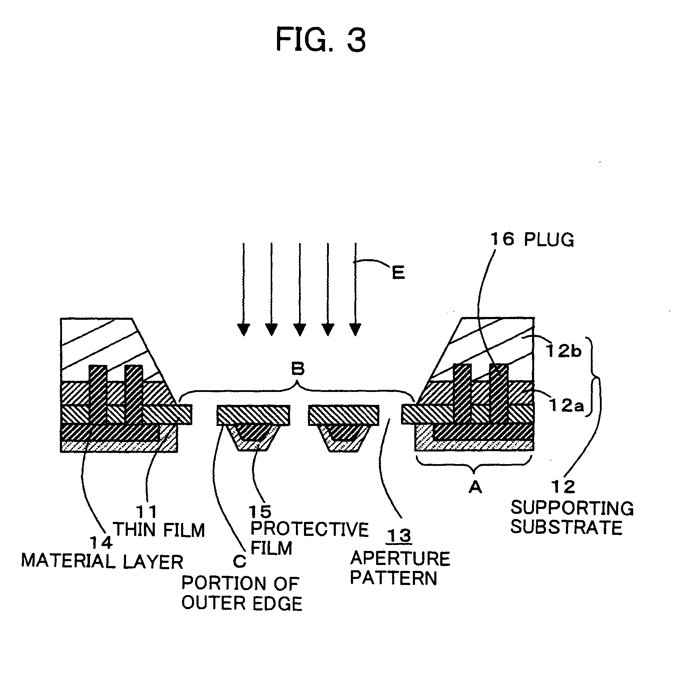

In addition, the embodiment of the second stencil mask in the present invention will be explained by using a cross sectional view in FIG. 3. As shown in FIG. 3, this stencil mask, that is similar to the first embodiment, is constituted by a supporting portion A and a membrane portion B.

Here, as the construction of the membrane portion B, as well as the first embodiment, the membrane portion B has the thin film 11 in which the aperture pattern 13 is set, the material layer 14 formed in the opposite side of the surface in which the supporting substrate 12 of the thin film 11 is set and the protective film 15 set in a state of covering this material layer 14, the material layer 14 and the protective film 15 is set in a region except for the portion of outer edge C of the aperture pattern 13. Note that in the present embodiment, as well as the first embodiment, the side on which the supporting substrate 12 in the thin film 11 is set is defined as the upper side of the thin film 11, the side on which the material layer 14 in the thin film 11 is set is defined as the lower side of the thin film 11.

About the supporting portion A, as well as the first embodiment, the supporting substrate 12 is set in a state of supporting the portion around the edge of the thin film 11, the supporting substrate 12 is a laminated structure where the substrate 12b is set in the portion around the edge of the thin film 11 through the insulating film 12a. Moreover, in the lower side of the thin film 11, the material layer 14 is set in a state of continuing from the membrane portion B, the material layer 14 is covered by the protective film 15. Further, in the stencil mask of the present embodiment, a plug 16 is embedded in a state of penetrating and reaches inside of the supporting substrate 12, the plug 16 is set in a state of being communicated with the material layer 14.

Here, the plug 16 is formed by a material having heat conductance higher than that of the thin film 11 and the supporting substrate 12. For example, the plug 16 may be formed by a conductive material consisting of aluminum equivalent to the material layer 14. As mentioned above, in the case that the plug 16 is formed by a material equivalent to the material layer 14, the material layer 14, that is similar to the plug 16, has heat conductance higher than that of the thin film 11 and the supporting substrate 12. As well, here the plug 16 is formed by a material equivalent to the material layer 14. However, it may be formed by different materials. However, it is preferable that the plug 16 and the material layer 14 are formed by the same material, because they can be formed in the same process.

Moreover, the plug 16 is embedded in pillar-shaped, in a state of penetrating the thin film 11 and the insulating film 12a and reaches inside of the substrate 12b, and a plurality of the plugs 16 are embedded along the side of inner and outer circumstances of the frame-shaped supporting substrate 12.

Here, for improving a state of radiating heat of the stencil mask, it is so preferable that the occupied volume of the plug 16 in the supporting substrate 12 be large. Hence, it is so preferable that the plug 16 is embedded as deep as possible inside the supporting substrate 12, and that the cross sectional area of the plug 16 is large. Moreover, by embedding a number of plugs 16, the occupied volume of the plug 16 may be made larger.

Here, it is defined that a plurality of pillar-shaped plug 16 is embedded along the side of inner and outer circumstances of the frame-shaped supporting substrate 12. However, for example, a frame-shaped plug 16 may be embedded along the frame-shaped supporting substrate 12, or a number of frame-shaped plugs 16 may be set from the side of inner circumstances to outer circumstance of the supporting substrate 12.

Moreover, the plug 16 in a state of penetrating the thin film 11 is communicated with the material layer 14 set in the lower side of the thin film 11 in the supporting portion A. Since the plug 16 is communicated with the material layer 14, the heat arising in the surface of the thin film 11 is radiated quickly from the material layer 14 to the plug 16, further radiated into the supporting substrate 12. As well, here the material layer 14 is set in communication with the plug 16, if the heat arising in the thin film 11 by irradiation of the charged particle beam E can be radiated quickly, the material layer 14 may not be set in communication with the plug 16.

According to the above mentioned construction of the second stencil mask, as well as the stencil mask of the first embodiment, since the protective film 15 is set in a state of covering the material layer 14 and the portion of outer edge C of the aperture portion 13 is not covered by the material layer 14 and the protective film 15, the effect similar to the first embodiment can be obtained. Moreover, since the plug 16 having heat conductance higher than that of the thin film 11 is embedded in a state of penetrating the thin film 11 and reaches the supporting substrate 12, the heat arising in the thin film 11 by irradiation of the charged particle beam E can be radiated quickly into the supporting substrate 12 through the plug 16.

Therefore, when placing the stencil mask on the upper side of the processing substrate with a predetermined interval, the contact of stencil mask and the processing substrate because of deformation by the heat can be prevented, and the interval from the stencil mask in all region of the processing substrate can be kept. Further, since deformation of the aperture pattern 13 by the heat can be prevented, displacement and deformation of the region where the charged particle beam E is irradiated can be prevented. Moreover, in the case that the supporting substrate 12 is set to contact with a cooling mechanism, since the cooled supporting substrate 12 quickly absorbs the heat of the thin film 11 through the plug 16, rising of the temperature of the thin film 11 can be prevented.

Further, according to the stencil mask of the present invention, the material layer 14 is communicated with the plug 16. Hence, the heat arising in the surface of the thin film 11 is radiated more quickly through the material layer 14 and the plug 16 into the supporting substrate 12.

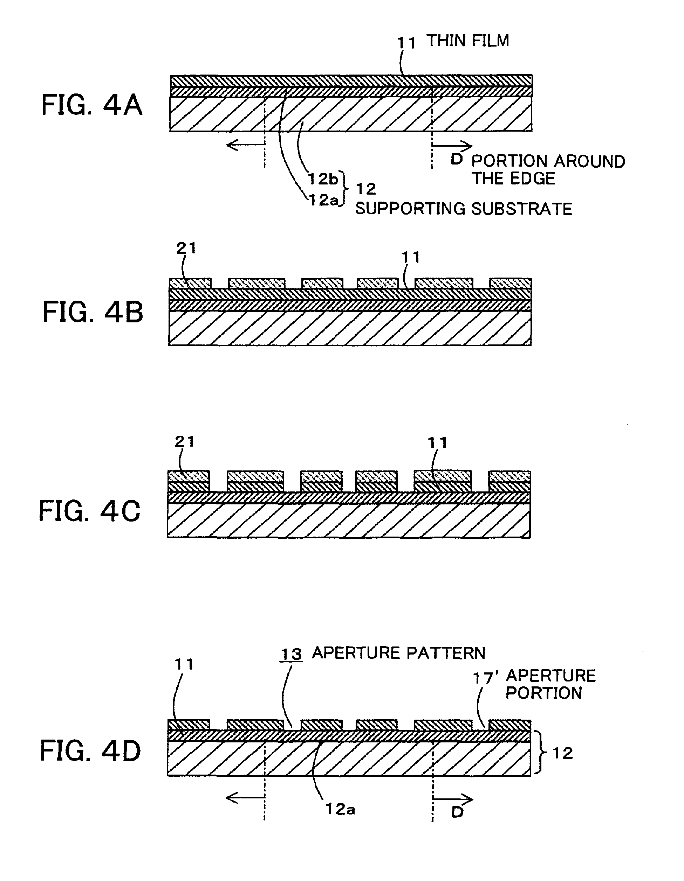

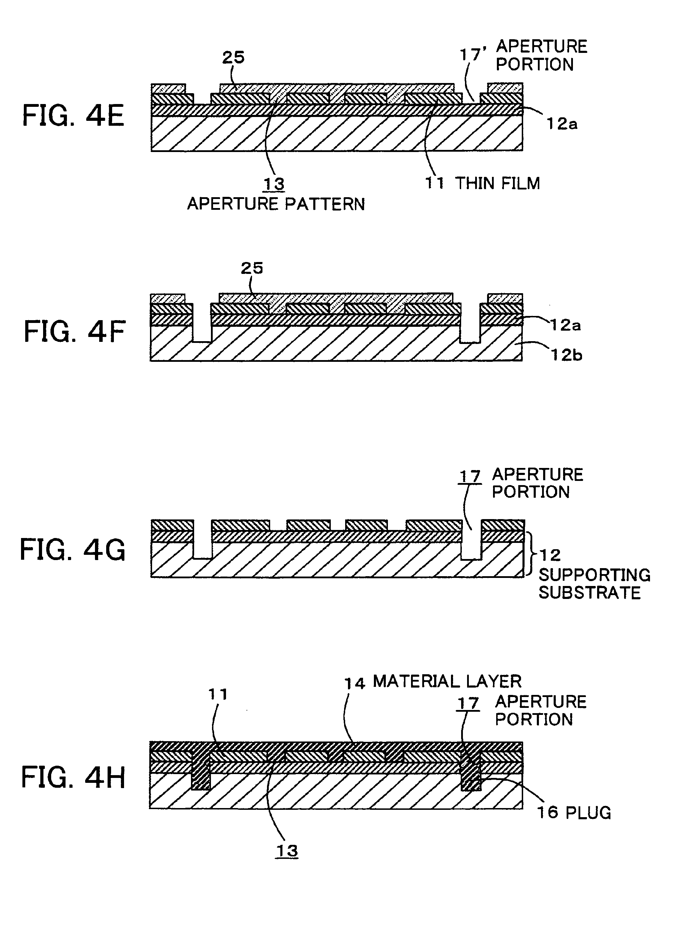

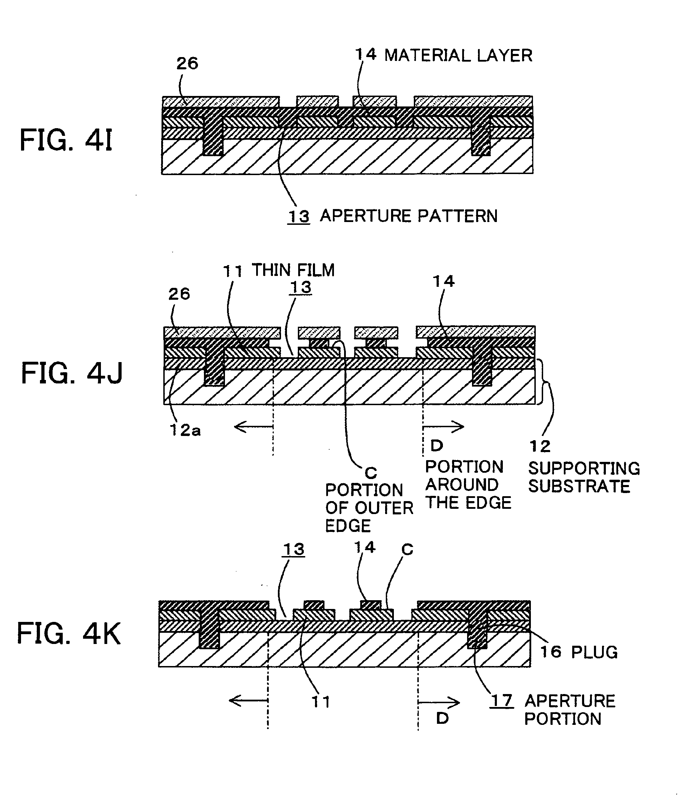

Moreover, an example of the embodiment in connection with a method of producing a second stencil mask in the present embodiment will be explained with cross sectional process views of FIG. 4A to FIG. 4K. Note that a construction equal to the construction explained in the first embodiment is explained with assigning a same number.

First, as shown in FIG. 4A, the insulating film 12a is formed on the substrate 12b to make the supporting substrate 12. Afterwards the thin film 11 is formed on the insulating film 12a. Here, the portion around the edge D of the supporting substrate 12 and the thin film 11 on the portion around the edge D constitutes the supporting portion A (refer to said FIG. 3), the thin film 11 inside the portion around the edge D constitutes the membrane portion B (refer to said FIG. 3).

Next, as shown in FIG. 4B, the resist pattern 21 is formed on the thin film 11. Afterward, as shown in FIG. 4C, by an etching using the resist pattern 21 for a mask, the thin film 11 is removed. Afterward, the resist pattern 21 is performed ashing removal. By the above process, as shown in FIG. 4D, the aperture pattern 13 reaching the insulating film 12a is formed in the thin film 11 covering inside the portion around the edge D of the supporting substrate 12 and an aperture portion 17' is formed in the thin film 11 covering the portion around the edge D of the supporting substrate 12.

Next, as shown in FIG. 4E, in a state of covering the thin film 11 where the aperture pattern 13 is set a resist pattern 25 is formed on the insulating film 12a to expose the aperture portion 17'. Afterward, as shown in FIG. 4F, by an etching where the resist pattern 25 is used as a mask, the insulating film 12a at the bottom of the aperture portion 17' and the substrate 12b are removed. After that, the resist pattern 25 is performed ashing removal. Herewith, as shown in FIG. 2G, the aperture portion 17 is formed.

Here, the depth of the aperture portion 17 is not limited especially, it may be as deep as a degree to embed a material for forming the plug sufficiently in the post process where the plug is formed in the aperture portion 17. However, it is preferable that the aperture portion is deeper, since the heat arising in the thin film 11 can be radiated from the plug into the supporting substrate 12 quickly because the plug formed in the aperture portion 17 can be formed longer.

Next, as shown in FIG. 4H, a material layer 14 is formed to cover the thin film 11 where the aperture pattern 13 is formed and to embed the aperture portion 17. Here, the material layer 14 and the plug 16 are made to be formed by a same material, the plug 16 is formed by embedding the aperture portion 17 with the material layer 14 like this.

Afterward, as shown in FIG.4I, a resist pattern 26 is formed on the material layer 14 to expose the material layer 14 on the aperture pattern 13. Next, as shown in FIG.4J, by an etching where the resist pattern 26 is used as a mask, the material layer 14 on the aperture pattern 13 is removed and the insulating film 12a is exposed, the material layer 14 covering the portion of outer edge C of the aperture pattern 13 in the thin film 11 is removed by over-etching. Moreover, in a state of continuing the material layer 14 on the thin film 11 covering inside of the portion around the edge D of the supporting substrate 12 the material layer 14 on the thin film 11 covering the portion around the edge D is left. Afterward, the resist pattern 26 is performed ashing removal.

Herewith, as shown in FIG. 4K, the material layer 14 is formed to cover the region except for the portion of outer edge C of the aperture pattern 13 in the thin film 11, and the material layer 14 formed on the thin film 11 covering the portion around the edge D of the supporting substrate 12 is set in communication with the plug 16 formed at the aperture portion 17.

The process after that is performed as well as the process explained by using FIG. 2I ~ FIG. 2P in the first embodiment. After the protective film 15 is formed to cover the thin film 11 in which the aperture pattern 13 is formed and the material layer 14, by patterning the protective film 15, the protective film 15 on the aperture pattern 13 and the protective film 15 covering the portion of outer edge C of the aperture pattern 13 are removed. Afterward, by removing inside of the portion around the edge D of the supporting substrate 12, the thin film 11 is exposed and the membrane portion B is formed.

According to the above mentioned method of producing the second stencil mask, as well as the first embodiment, the stencil mask in a state where the protective film 15 is set in a state of covering the material layer 14 and the portion of outer edge C of the aperture pattern 13 is not covered with the material layer 14 and the protective film 15 can be produced.

Moreover, as explained by using FIG. 4H, the material layer 14 is formed to cover the thin film 11 in which the aperture pattern 13 is formed and to embed the aperture portion 17. Herewith, the plug 16 having heat conductance higher than that of the thin film 11 and the supporting substrate 12 is formed in a state of penetrating the thin film 11 and reaches inside of the supporting substrate 12 on the portion around the edge D of the supporting substrate 12. Moreover, by forming the plug 16 and the material layer 14 with a same material, the plug 16 and the material layer 14 can be formed at a same process. Further, as explained by using FIG. 4J, by patterning the material layer 14, since the material layer 14 is left on the thin film 11 covering the portion around the edge D of the supporting substrate 12, the plug 16 formed at the aperture portion 17 can be communicated with the material layer 14.

Note that the present invention is not limited to the above embodiments and includes modifications within the scope of the claims.

### INDUSTRIAL APPLICABILITY

The present invention can apply to application such as an ion implantation process, an exposure process, a process of forming a film or an etching process that is performing process by placing a stencil mask in the upper side of a processing substrate and by irradiating a charged particle beam to a process substrate through a stencil mask.

## Claims

1. A stencil mask comprising:
a thin film (11) having an aperture pattern (13), and;
a material layer (14) set in a region except for a portion (c) of outer edge of said aperture pattern (13) in the side of a principal surface of said thin film (11) and having heat conductance higher than that of said thin film (11).

2. A stencil mask as set forth in claim 1, wherein a protective film (15) is set in a state of covering said material layer (14).

3. A stencil mask as set forth in claim 2, wherein said protective film (15) is set in a state of covering said material layer (14) and is set in a region except for a portion (c) of outer edge of said aperture pattern (13).

4. A method of producing a stencil mask, comprising:
a step of forming a thin film (11) on a supporting substrate (12);
a step of forming an aperture pattern (13) reaching said supporting substrate (12) on a thin film (11) covering the inside of a portion around the edge of said supporting substrate (12);
a step of forming a material layer (14) having heat conductance higher than that of said thin film (11) to cover said thin film (11) in which said aperture pattern (13) is formed;
a step of removing said material layer (14) covering on said aperture pattern (13) and a portion (c) of outer edge of said aperture pattern, and;
a step of removing inside a portion around the edge of said supporting substrate (12) to expose said thin film (11).

5. A method of producing a stencil mask as set forth in claim 4, further comprising a step of forming a protective film (15) to cover said material layer (14) after said step of removing said material layer (14) and before said step of exposing said thin film (11).

6. A method of producing a stencil mask as set forth in claim 5, wherein the step of forming said protective film (15), comprises:
a step of forming a protective film (15) to cover said thin film (11) in which said aperture pattern (13) is formed and said material layer (14), and;
a step of removing said protective film (15) covering on said aperture pattern (13) and a portion (c) of outer edge of said aperture pattern.

7. A method of producing a stencil mask as set forth in claim 5, wherein in said step of forming said protective film (15), an oxide film of said material layer is formed by performing a passive state process of the surface of said material layer.

8. A stencil mask comprising:
a thin film (11) having an aperture pattern (13);
a supporting substrate (12) supporting a portion around the edge of said thin film (11);
a material layer (14) set in a region except for a portion (c) of outer edge of said aperture pattern in the side of a principal surface of said thin film (11) and having heat conductance higher than that of said thin film (11), and;
a plug (16) embedded in a state of contacting with said thin film (11), reaching inside of said supporting substrate (12) and having heat conductance higher than that of said thin film (11) and said supporting substrate (12).

9. A stencil mask as set forth in claim 8, wherein said material layer (14) is communicated with said plug (16).

10. A stencil mask as set forth in claim 8, further comprising a protective film (15) covering said material layer (14).

11. A stencil mask as set forth in claim 10, wherein said protective film (15) is set in a state of covering said material layer (14) and is set in a region except for a portion (c) of outer edge of said aperture pattern.

12. A method of producing a stencil mask, comprising:
a step of forming a thin film (11) on a supporting substrate (12);
a step of forming an aperture pattern (13) reaching said supporting substrate (12) in said thin film (11) covering inside a portion around the edge of said supporting substrate (12), and forming an aperture portion reaching inside of said supporting substrate (12) in said thin film (11) covering a portion around the edge of said supporting substrate and said supporting substrate (12);
a step of forming a material layer (14) having heat conductance higher than that of said thin film (11) to cover said thin film (11) in which said aperture pattern (13) is formed, and forming a plug (16) having heat conductance higher than that of said thin film (11) and said supporting substrate (12) at said aperture portion, and;
a step of patterning said material layer (14) to remove said material layer covering on said aperture pattern (13) and inside a portion (c) of outer edge of said aperture pattern, and;
a step of removing inside a portion around the edge of said supporting substrate (12) to expose said thin film (11).

13. A method of producing a stencil mask as set forth in claim 12, wherein in said step of forming said plug (16), said material layer (14) is formed to cover said thin film (11) in which said aperture pattern (13) is formed and to embed said aperture portion.

14. A method of producing a stencil mask as set forth in claim 12, further comprising said step of forming a protective film (15) to cover said material layer (14) after said step of removing said material layer (14) and before said step of exposing said thin film (11).

15. A method of producing a stencil mask as set forth in claim 14, wherein a step of forming said protective film (15), comprises:
a step of forming a protective film (15) to cover said thin film (11) in which said aperture pattern (13) is formed and said material layer (14), and;
a step of removing said protective film (15) covering on said aperture pattern (13) and a portion (c) of outer edge of said aperture pattern.

16. A method of producing a stencil mask as set forth in claim 14, wherein in said step of forming said protective film (15), an oxide film of said material layer is formed by performing a passive state process of the surface of said material layer.
